(19) Europäisches Patentamt / European Patent Office / Office européen des brevets

(11) **EP 4 390 382 A1**

(12) # DEMANDE DE BREVET EUROPEEN

(43) Date de publication:
**26.06.2024 Bulletin 2024/26**

(21) Numéro de dépôt: **23219647.7**

(22) Date de dépôt: **22.12.2023**

(51) Classification Internationale des Brevets (IPC):
**G01N 23/201** (2018.01)    **G01N 23/2055** (2018.01)
**G03F 7/00** (2006.01)    **G01B 15/04** (2006.01)

(52) Classification Coopérative des Brevets (CPC):
**G01N 23/201; G01B 15/04; G01N 23/2055;**
**G03F 7/70625; G03F 7/706843;** G01N 2223/0561;
G01N 2223/0566; G01N 2223/1016;
G01N 2223/305; G01N 2223/3305;
G01N 2223/3306; G01N 2223/611

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **23.12.2022 FR 2214428**

(71) Demandeur: **Commissariat à l'énergie atomique et aux énergies alternatives**
**75015 Paris (FR)**

(72) Inventeurs:
• **FREYCHET, Guillaume**
  **38054 GRENOBLE CEDEX 9 (FR)**
• **GERGAUD, Patrice**
  **38054 GRENOBLE CEDEX 9 (FR)**

(74) Mandataire: **Lavoix**
**2, place d'Estienne d'Orves**
**75441 Paris Cedex 09 (FR)**

(54) **PROCÉDÉ DE MESURE METTANT EN OEUVRE UNE TECHNIQUE PAR DIFFUSION DES RAYONS X AUX PETITS ANGLES EN INCIDENCE RASANTE - GISAXS; SYSTÈME INSTRUMENTAL ET PRODUIT PROGRAMME D'ORDINATEUR ASSOCIÉS**

(57)    Ce procédé consistant à : placer un réseau de lignes gravé sur un échantillon (10) dans un faisceau de rayons X de manière à créer un désalignement ($\varphi$) entre le réseau de lignes et un plan d'incidence (PI); éclairer (130) le réseau de lignes sous un angle d'incidence (a) donné ; mesurer (140) la grandeur sur la figure de diffraction obtenue pour une pluralité de tâches de Bragg, la pluralité de tâches de Bragg comportant une ou plusieurs tâche(s) de Bragg d'ordre positif et une ou plusieurs tâche(s) de Bragg d'ordre négatif.

FIG.1

**EP 4 390 382 A1**

**Description**

La présente invention concerne un procédé de mesure par diffusion des rayons X aux petits angles en incidence rasante - GISAXS (pour « grazing-incidence small-angle X-ray scattering »)

Pour suivre la loi de Moore et permettre l'augmentation du nombre de puces gravées par unité de surface, la dimension des composants (notamment des transistors) est en constante diminution.

Leurs dimensions caractéristiques sont maintenant inférieures à 10 nm.

La métrologie nécessaire pour visualiser de tels composants avec une précision sub-nanométrique a entrainé le développement de nouvelles techniques pour contourner les limites de résolution des techniques standards, telles que la microscopie à force atomique ou encore la microscopie électronique à balayage.

Une des techniques prometteuses est celle de la diffusion des rayons X à petits angle, notamment la technique de diffusion des rayons X à petits angles en incidence rasante. Plusieurs études au synchrotron et avec des sources de laboratoire ont été menées pour valider le fait que la technique GISAXS permet de répondre à cette problématique.

Cependant, la mise en oeuvre de cette technique reste complexe et le relevé des mesures fastidieux.

Le but de la présente invention est de proposer un procédé de mesure plus efficace lors de la mise en oeuvre de la technique GISAXS.

Pour cela, l'invention a pour objet un procédé de mesure mettant en oeuvre une technique par diffusion des rayons X aux petits angles en incidence rasante d'une grandeur relative à un motif périodique formant un réseau de lignes, qui est gravé sur un échantillon, le procédé consistant à : placer le réseau de lignes dans un faisceau de rayons X de manière à créer un désalignement $\varphi$ entre le réseau de lignes et un plan d'incidence; éclairer le réseau de lignes sous un angle d'incidence $\alpha$ donné ; mesurer la grandeur sur la figure de diffraction obtenue pour une pluralité de tâches de Bragg, la pluralité de tâches de Bragg comportant une ou plusieurs tâche(s) de Bragg d'ordre positif et une ou plusieurs tâche(s) de Bragg d'ordre négatif.

Suivant des modes particuliers de réalisation, le procédé comporte une ou plusieurs des caractéristiques suivantes, prises isolément ou suivant toutes les combinaisons techniquement possibles :

- le désalignement est caractérisé par un angle de désalignement, l'angle de désalignement est sélectionné entre 0,01° et 1°, de préférence égale à 0,1°.
- l'étape de mesure est itérée pour une succession d'angles d'incidence.
- étant défini un ensemble d'angles d'incidence s'étendant entre une valeur minimale et une valeur maximale, par pas de longueur prédéfinie, l'étape de mesure est itérée pour chaque angle d'incidence dudit ensemble.
- la grandeur mesurée est sélectionnée parmi une position de la tâche de Bragg considérée dans l'espace réciproque et une intensité (I) de la tâche de Bragg considérée.
- suite à l'étape de mesure, les grandeurs mesurées permettent d'ajuster une courbe d'intensité qui dépend d'un facteur de forme du réseau de lignes, afin de déterminer un profil probable du réseau de lignes.

L'invention a également pour objet un système instrumental du type GISAXS, comportant un calculateur et un détecteur connecté au calculateur, caractérisé en ce que le calculateur est convenablement programmé pour que le système instrumental mette en oeuvre le procédé précédent.

L'invention a également pour objet un produit programme d'ordinateur comportant des instructions logicielles qui, lorsqu'elles sont exécutées par le calculateur d'un système instrumental conforme au système précédent, permet à ce dernier de mettre en oeuvre un procédé conforme au procédé précédent.

L'invention et ses avantages seront mieux compris à la lecture de la description détaillée qui va suivre d'un mode de réalisation particulier, donné uniquement à titre d'exemple illustratif et non limitatif, cette description étant faite en se référant aux dessins annexés sur lesquels :

La figure 1 est une représentation schématique d'un système instrumental pour la mise en oeuvre du procédé de mesure selon l'invention, fondée sur la mise en oeuvre d'une technique GISAXS ;

La figure 2 est une image obtenue au moyen du système instrumental de la figure 1, rapportée dans l'espace réciproque, pour un angle de désalignement nul entre les lignes d'un réseau de lignes et le plan d'incidence ;

La figure 3 est un relevé des mesures de la coordonnée de position qz en fonction de l'ordre de la tâche de Bragg dans l'image de la figure 2 pour différentes valeurs de l'angle d'incidence ;

La figure 4 est une image obtenue au moyen du système instrumental de la figure 1, rapportée dans l'espace réciproque, pour un angle de désalignement non nul entre les lignes d'un réseau de ligne et le plan d'incidence ;

La figure 5 est un relevé des mesures de la coordonnée de position qz en fonction de l'ordre de la tâche de Bragg dans l'image de la figure pour différentes valeurs de l'angle d'incidence ;

La figure 6 est une représentation sous forme de blocs d'un mode de réalisation du procédé de mesure selon l'invention ; et,

La figure 7 illustre l'intérêt du procédé de mesure de la figure 6 pour deux réseaux de lignes présentent des facteurs de forme différents.

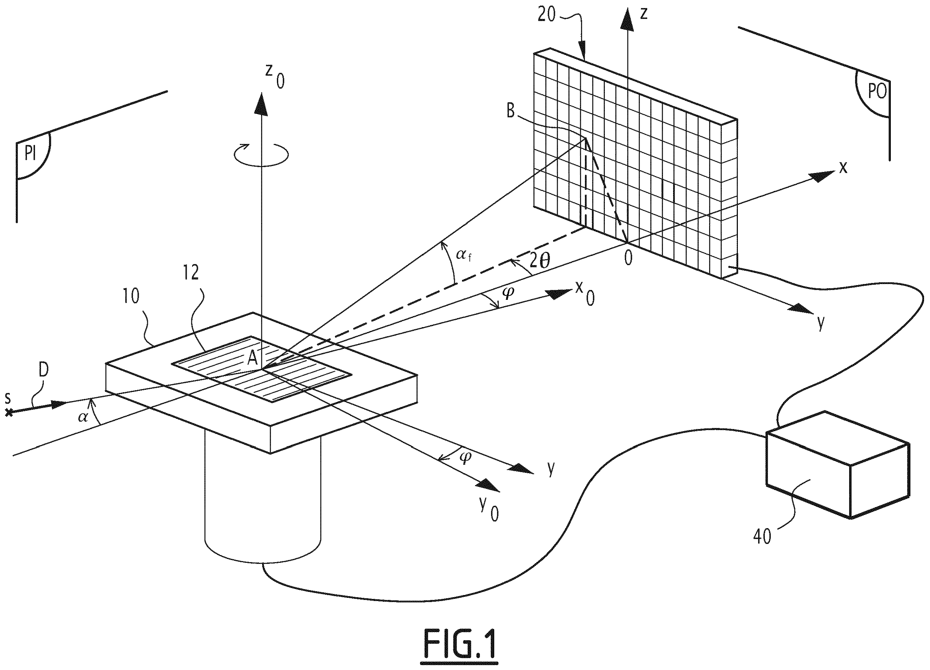

La figure 1 représente un système instrumental 1 permettant de mettre en oeuvre le procédé de mesure selon l'invention sur un échantillon 10.

Le procédé de mesure selon l'invention est fondé sur une technique de mesure par diffusion des rayons X aux petits angles en incidence rasante - GISAXS.

Selon cette technique, une source S éclaire l'échantillon 10 et la lumière réfléchie par l'échantillon 10 est imagée dans un plan d'observation PO.

Un repère x, y, z du système instrumental est par exemple attaché au centre O du plan d'observation PO de sorte que la direction normale à ce plan soit la direction x et le plan lui-même soit défini par les directions y et z.

L'échantillon 10 est par exemple un composant microélectronique sur la surface pane duquel est gravé une mire 12, par exemple par mise en oeuvre d'un procédé de lithographie. La mire 12 présente un réseau de lignes.

Un repère x0, y0, z0 est attaché au centre A de la mire 12, de sorte que la direction z0 corresponde à la normale à la surface de l'échantillon 10, que la direction x0 corresponde à la direction des lignes du réseau de lignes de la mire 12, et que la direction y0 soit orthogonale aux directions z0 et x0, i.e. orthogonale à la direction des lignes du réseau de lignes.

L'échantillon 10 est placé sur un support 30 du système instrumental. De préférence et pour simplifier la présente description, l'échantillon 10 est orienté de sorte que l'axe z0 soit parallèle à l'axe z du système instrumental et que le plan x0y0 de la surface de l'échantillon coïncide avec le plan xy. Cependant et plus généralement, il peut exister un angle entre ces deux directions, dont il faut alors tenir compte lors de l'analyse.

La source S de rayon X émet un faisceau de rayon X selon une direction d'incidence D sur la mire 12 de l'échantillon 10.

Le plan d'incidence PI correspond au plan z, x. La direction y est donc la direction normale au plan d'incidence PI.

Une mesure GISAXS s'effectue avec un angle d'incidence $\alpha$, entre la direction x et D, faible, par exemple de quelques radians.

Le support 30 permet de faire tourner l'échantillon 10 autour de la direction z de manière à modifier un angle $\varphi$ entre la direction x0 et la direction x, qui est également l'angle entre la direction y0 et la direction y. L'angle $\varphi$, lorsqu'il n'est pas nul, fait qu'il y a un désalignement entre la direction des lignes du réseau de lignes et le plan d'incidence PI.

Le faisceau incident tombe au point A de l'échantillon. Il est réfléchi et diffracté par la mire 12 de manière à former une image dans le plan d'observation PO.

Un détecteur 20 est placé dans le plan d'observation PO. Il est par exemple composé d'une matrice de capteurs disposés selon la direction y et la diction z.

L'intensité I au point B du plan d'observation PO, mesurée par le capteur localisé au point B, dépend de l'angle $2\theta$ entre la direction AO et la direction AB.

Le détecteur 20 est connecté à un dispositif électronique, représenté de manière schématique sur la figure 1 par un cube portant la référence 40.

Le dispositif 40 comporte une électronique de contrôle permettant de commander le support 30 pour qu'il positionne l'échantillon 10 selon une valeur de consigne de l'angle $\varphi$.

Le dispositif 40 comporte également une électronique d'acquisition permettant d'effectuer des prétraitements adaptés sur les signaux délivrés par chacun des capteurs du détecteur 20 et à les numériser.

Le dispositif 40 comporte en outre un calculateur pour le traitement des signaux prétraités et numérisés. Le calculateur est un ordinateur comportant des moyens de calcul, tels qu'un processeur, et des moyens de mémorisation, tels qu'une mémoire. La mémoire stocke notamment les instructions de programmes d'ordinateur, en particulier un programme dont l'exécution permet la mise en oeuvre du procédé de mesure selon l'invention.

Comme connu en soi, l'image dans le plan d'observation PO est en relation avec la transformée de Fourier spatiale de la zone éclairée par le faisceau incident.

Dans le cadre de mesure en incidence rasante, dans l'espace réciproque, la fréquence spatiale q s'écrit, en considérant les fréquences spatiales $q_x$, $q_y$ et $q_z$, respectivement associées aux directions x, y et z du repère lié au plan d'observation PO :

$$q_x = \frac{2\pi}{\lambda}\left[\cos\left(\alpha_f\right).\cos(2\theta) - \cos(\alpha)\right] \tag{1}$$

$$q_y = \frac{2\pi}{\lambda}\left[\cos\left(\alpha_f\right).\sin(2\theta)\right] \tag{2}$$

$$q_z = \frac{2\pi}{\lambda}\big[\sin(\alpha_f) + \sin(\alpha)\big] \qquad\qquad (3)$$

où $\alpha$ est l'angle d'incidence des rayons X sur l'échantillon, $\alpha_f$ est l'angle du rayon réfléchi hors du plan xy, $2\theta$ est l'angle de rotation autour de l'axe z du plan d'incidence du rayon réfléchi et $\lambda$ est la longueur d'onde.

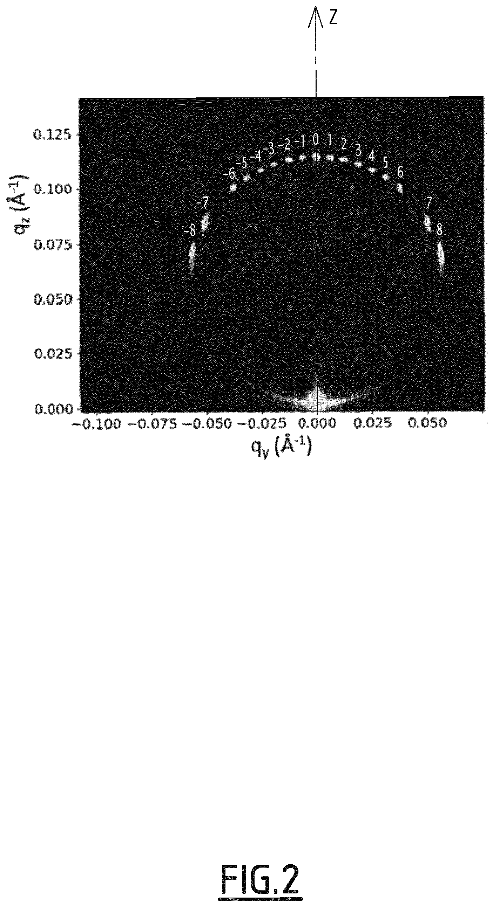

La figure 2 représente une image GISAXS rapporté dans l'espace réciproque $q_y$, $q_z$. Cette image est obtenue pour un réseau de lignes parfaitement aligné avec le faisceau de rayons X incident, c'est-à-dire avec un angle $\varphi$ nul.

Cette image présente, outre une tâche autour de l'origine correspond au faisceau réfléchi, une figure de diffraction créée par la mire 12.

La figure de diffraction est composée d'une pluralité de tâches, dites de Bragg, disposées sur un arc de cercle. Chaque tâche est associée à un ordre de diffraction.

On montre qu'une tâche est en fait l'intersection d'une tige de diffraction ou tige de Bragg et de la sphère dite d'Ewald. L'ordre de la tâche de Bragg est en fait l'ordre de la tige de Bragg associée. La modification de l'angle d'incidence du faisceau de rayons X permet de sonder la tige de Bragg.

Pour la tâche située sur l'axe z ($q_y = 0$), on parle d'ordre principal ou d'ordre nul.

Puis, du côté des $q_y$ positifs, lorsque l'on se déplace à l'écart de l'axe z, on observe successivement les tâches de Bragg associées aux ordres de Bragg positifs 1, 2, 3, 4, 5, 6, 7, et 8.

Pour les $q_y$ négatifs, lorsque l'on se déplace à l'écart de l'axe z, on observe les tâches de Bragg associées aux ordres de Bragg négatifs -1, -2, -3, -4, -5, -6, -7 et -8.

On constate que la figure de diffraction est totalement symétrique par rapport à l'axe z. A la tâche de Bragg d'ordre p correspond par symétrie par rapport à l'axe z la tâche de Bragg d'ordre-p.

En modifiant l'angle d'incidence $\alpha$, il est possible de sonder les différents ordres de Bragg.

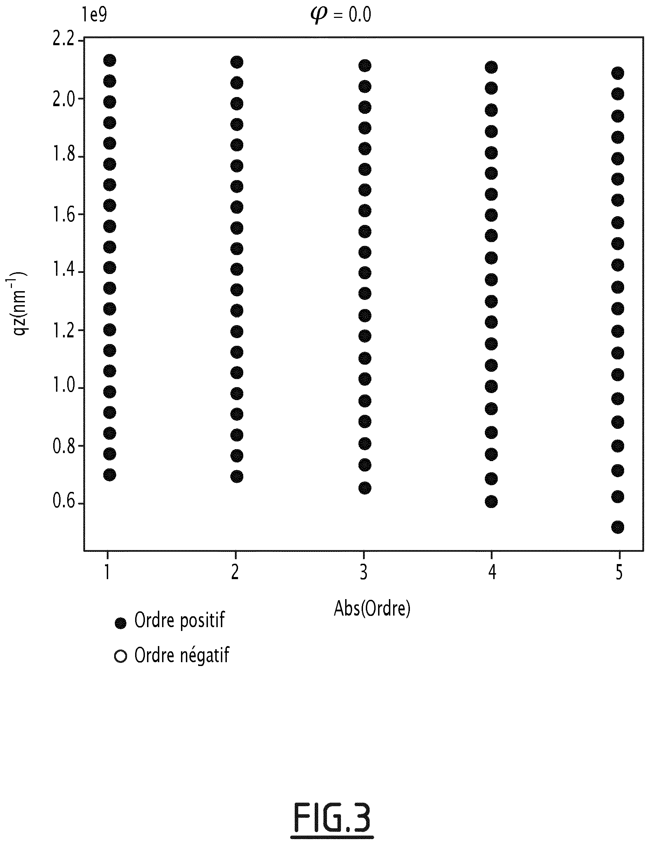

La figure 3 représente ainsi les mesures de la position dans l'espace réciproque selon la direction z, $q_z$, pour les différents taches de Bragg d'ordres positifs et pour une succession de 21 valeurs de l'angle d'incidence $\alpha$.

Selon l'état de la technique, on ne mesure la position des tâches de Bragg que pour les ordres positifs.

En effet, d'un point de vue théorique, il est possible de calculer exactement la position dans l'espace réciproque (qy, qz) de chaque tâche de diffraction. Ces calculs sont par exemple présentés dans l'article de M. Yan et A. Gibaud, « On the intersection of grating truncation rods with the Ewald sphère studied by grazing-incidence small-angle X-ray scattering", Journal of Applied Crystallography (2007), 40, 1050-1055.

Lorsque le réseau de lignes est parfaitement aligné avec le faisceau de rayons X, les cordonnées dans l'espace réciproque $q_y$, $q_z$ de la tâche de Bragg d'ordre p s'expriment selon l'équation suivante :

$$\begin{cases} q_y = \dfrac{2p\pi}{b} \\ q_z = \dfrac{2\pi}{\lambda}.\cos\alpha.\sin\alpha.\left\{1 + \left[1 - \left(\dfrac{p\lambda}{b.\sin\alpha}\right)^2\right]^{1/2}\right\} \end{cases}$$

où $p$ est l'ordre de la tâche de Bragg, $b$ est la période spatiale de répétition du motif dans la structure de l'échantillon (i.e. pour un réseau de lignes, c'est le pas - ou distance - entre deux lignes voisines) selon la direction y, $\lambda$ est la longueur d'onde et $\alpha$ est l'angle d'incidence du faisceau de rayons X.

Pour $q_z$, on constate que l'ordre p intervient dans un terme au carré. En conséquence, le signe de l'ordre n'a pas d'effet sur la valeur de $q_z$. La figure de diffraction est totalement symétrique par rapport à l'axe z. La mesure de $q_z$ pour la tâche d'ordre p est égale à la mesure de $q_z$ sur l'ordre -p. Il n'y a donc pas plus d'information à collecter si en plus des ordres positifs, on effectue les mesures sur les ordres négatifs.

Cependant, lorsque le réseau de lignes n'est plus aligné, la figure de diffraction n'est plus symétrique par rapport à l'axe z.

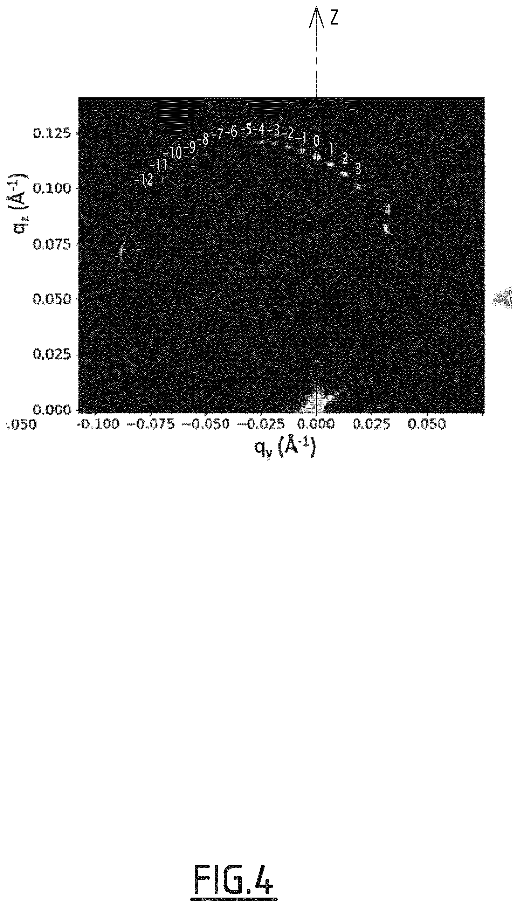

La figure 4 représente une image GISAXS rapportée dans l'espace réciproque $q_y$, $q_z$. Cette image est obtenue pour un réseau de lignes volontairement désaligné avec le faisceau X incident, c'est-à-dire avec un angle $\varphi$ non-nul (en l'occurrence égal à 0,1°).

Sur cette image, la tâche autour de l'origine correspond encore au faisceau réfléchi, mais la figure de diffraction créée par la mire 12 est maintenant asymétrique.

Elle est composée de tâches de Bragg disposées sur un arc de cercle, mais ces tâches ne sont plus disposées symétriquement par rapport à l'axe z.

Là encore, d'un point de vue théorique, il est possible de calculer exactement la position dans l'espace réciproque $q_y$, $q_z$ de chaque tâche de diffraction.

Lorsque le réseau de lignes n'est plus aligné, les cordonnées dans l'espace réciproque $q_y$, $q_z$ s'expriment selon l'équation 2 suivante :

$$\begin{cases} q_y = \dfrac{2\pi p.\cos\varphi}{b} - \dfrac{2\pi.\sin^2\alpha.\cos\varphi.\sin\varphi}{\lambda}.\left\{1 + \left[1 - \dfrac{\lambda^2 p^2}{b^2.\sin^2\alpha.\cos^2\varphi}\left(1 - \dfrac{2b.\sin\varphi}{p\lambda}\right)\right]^{1/2}\right\} \\[4mm] q_z = \dfrac{2\pi.\sin\alpha.\cos\alpha.\cos\varphi}{\lambda}.\left\{1 + \left[1 - \dfrac{\lambda^2 p^2}{b^2.\sin^2\alpha.\cos^2\varphi}\left(1 - \dfrac{2b.\sin\varphi}{p\lambda}\right)\right]^{1/2}\right\} \end{cases}$$

On constate que le signe de l'ordre p influe maintenant sur la valeur de la position $q_z$ (et sur la valeur de la position $q_y$).

Le procédé de mesure selon l'invention utilise avantageusement cette asymétrie, en réalisant, pour un même angle d'incidence $\alpha$, des mesures de la position et/ou de l'intensité I des tâches de Bragg pour les ordres positifs mais aussi pour les ordres négatifs de la figure de diffraction.

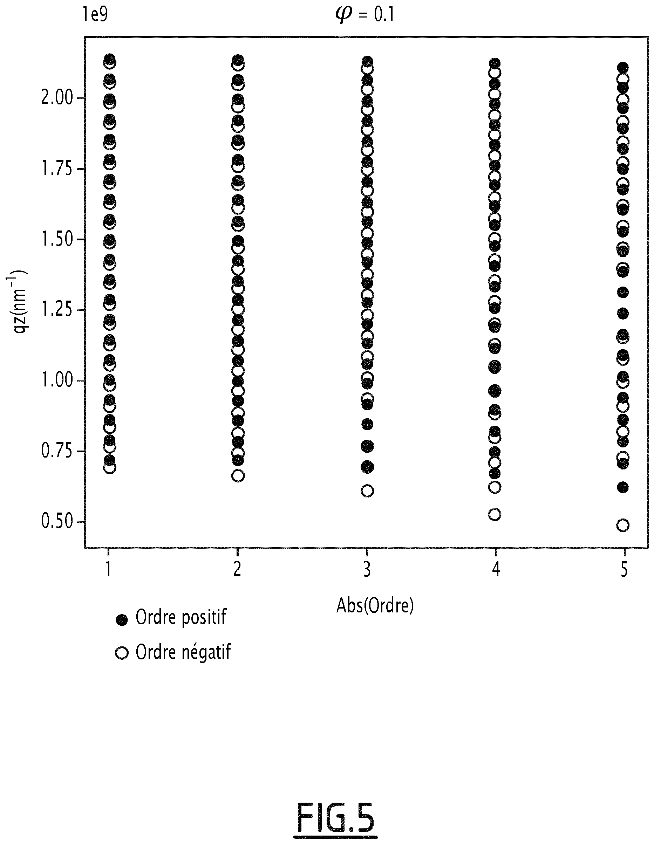

La figure 5 représente ainsi les mesures de position $q_z$ pour les différents ordres positifs et négatifs et pour une succession de 21 valeurs de l'angle d'incidence $\alpha$. Les mesures sur les ordres positifs sont indiquées par un rond noir et les mesures sur les ordres négatifs sont indiquées par un rond blanc (l'ordre étant donné en valeur absolue).

Ainsi, pour une configuration expérimentale (angle d'incidence $\alpha$ donné) les mesures sur les ordres positifs et les ordres négatifs permet de doubler le nombre d'informations collectées sensiblement dans le même laps de temps.

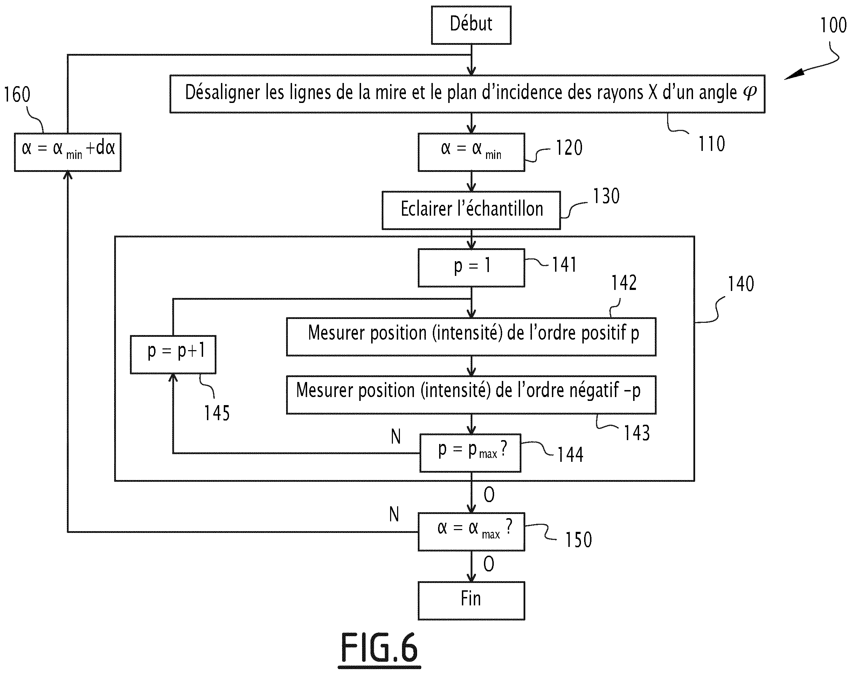

Un mode de réalisation du procédé de mesure selon l'invention est présenté à la figure 6.

Le procédé de mesure 100 débute par une étape 110 consistant à orienter la mire 12 par rapport au plan d'incidence PI de telle sorte que le réseau de lignes soit désaligné par rapport au plan d'incidence, c'est-à-dire qu'il existe un angle φ non nul entre la direction des lignes et la direction x. Il est à souligné que cet angle de désalignement n'a pas à être fixé de manière rigoureuse. Ce que l'on cherche est la création d'une asymétrie dans la figure de diffraction.

Puis, dans une étape 120, l'angle d'incidence $\alpha$ est initialisé. Par exemple, si l'on veut explorer un ensemble d'angles d'incidence entre un angle minimal $\alpha$ min et un angle maximal $\alpha$ max séparés d'un pas $d\alpha$, dans l'étape 120 l'angle $\alpha$ est initialisé à la valeur $\alpha min$. Par exemple $\alpha$ min est égal à 0,5°, $\alpha$ max à 1,5° et le pas $d\alpha$ est égal à 0,05°, soit 21 valeurs de l'angle d'incidence.

À l'étape 130, l'échantillon est éclairé par le faisceau de rayons X de manière à produire une image dans le plan d'observation.

Cette image est analysée à l'étape 140.

Plus précisément, dans une étape 141, l'ordre p est initialisé à la valeur unité.

À l'étape 142, on mesure par exemple la position $q_z$ et l'intensité I de la tâche de Bragg associée à l'ordre p positif puis à l'étape 143 en mesure la position $q_z$ et l'intensité I de la tâche de Bragg associée à l'ordre -p négatif.

Dans l'étable 144, on vérifie un critère sur la fin de l'analyse de l'image courante. Par exemple, le nombre d'ordres considérés est limité à un ordre maximal pmax.

Si le critère de l'étape 144 n'est pas vérifié, l'ordre p est incrémenté d'une unité et les étapes de mesures sont itérées.

Si à l'étape 144 le critère est vérifié, le procédé 100 passe à une étape 150 de vérification d'une contrainte sur la valeur de l'angle d'incidence. Si la valeur maximale $\alpha$ max n'a pas été atteinte, l'angle d'incidence est augmenté et le dispositif expérimental préparé avec ce nouvel angle d'incidence. Les étapes 130 d'éclairage de l'échantillon avec ce nouvel angle d'incidence et d'analyse de l'image obtenue sont itérées.

Si à l'étape 150, l'angle d'incidence a atteint la borne supérieure de l'intervalle à explorer, alors le procédé prend fin.

On obtient par exemple le relevé de la figure 5.

Dans le mode de réalisation de la figure 1, c'est l'orientation du composant dans le faisceau de rayons X qui est modifié pour faire varier l'angle d'incidence. En variante, le composant est fixe et c'est la source qui est déplacée pour faire varier l'angle d'incidence. Le déplacement de la source peut être réel ou virtuel en utilisant un système de lentilles adaptées.

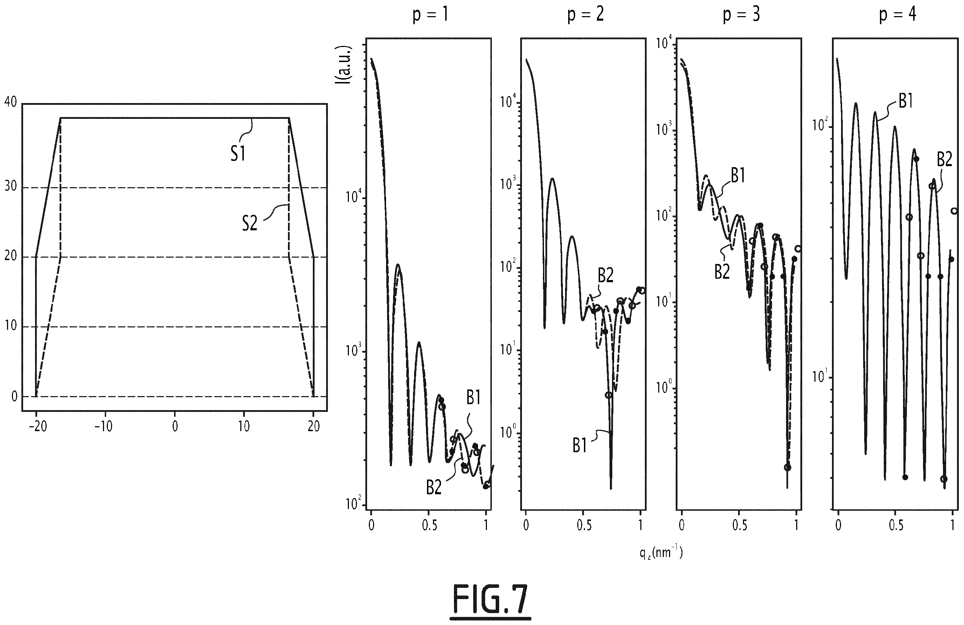

La figure 7 illustre l'intérêt du procédé selon l'invention. Dans un plan orthogonal z0, y0, les lignes du réseau de lignes de la mire présentent un profil. Par exemple, sur la partie gauche de la figure 7, S1 représente le profil transverse d'une ligne d'un premier réseau et S2 représente le profil transverse d'une ligne d'un second réseau. Par exemple ces deux réseaux sont réalisés par lithographie mais en modifiant la durée d'exposition. A l'issue d'une opération de lithographie permettant de graver sur l'échantillon le réseau de lignes mais surtout d'autres composants d'un circuit, il est souhaitable de pouvoir savoir si le profil des lignes est le profil S1 ou le profil S2 afin de vérification de la qualité de la lithographie réalisée.

Sur la partir droite de la figure 7 sont représentés différents graphes. Chaque graphe représente, pour un ordre p donné, l'intensité I (exprimée en unités normalisées a.u.) en fonction de la position $q_z$ pour le profil S1 (courbe B1) et le profil S2 (courbe B2) respectivement. Les courbes d'intensité B1 et B2 sont obtenues au moyen de simulations numériques à partir des profils S1 ou S2.

Ainsi, le fait de multiplier les mesures de position et d'intensité pour les ordres positifs et les ordres négatifs permet très rapidement de savoir quel est le profil des lignes effectivement gravé.

Les grandeurs mesurées (position et intensité) sont ajustées à une courbe d'intensité qui dépend d'un facteur de forme du réseau de lignes et ainsi déterminer le profil le plus probable des lignes du réseau de lignes.

En l'occurrence, sur la figure 7, les mesures étant mieux ajustées à la courbe B1, on en conclut que les lignes de la mire 12 présentent le profil S1.

Il peut y avoir peu de différence entre le signal de deux réseaux de lignes ayant des profils différents. Avec la mise en oeuvre du procédé de mesure selon l'invention, en réalisant deux fois plus de points de mesure, cela permet de décrire plus précisément la courbe d'intensité de la tige de Bragg et permettre de remonter au profil du réseau de ligne.

Le procédé de mesure de la dimension critique d'un objet périodique (comme le réseau de ligne de la mire) par rupture de la symétrie de mesure permet un doublement de l'efficacité et par conséquent diviser par deux le temps de mesures. Le gain en temps ainsi obtenu est primordial dans des procédés de fabrication en flux tendu pour la microélectronique.

Ce procédé de mesure est original car il va à l'encontre de la pratique courante de la communauté utilisant la technique GISAXS. Selon l'état de la technique le réseau de lignes est toujours aligné avec le faisceau de rayons X et, par conséquent, uniquement une partie (i.e. la moitié) de la figure de diffraction est utilisée pour les mesures et la collecte d'informations.

Il est à noter que la mise en oeuvre du procédé de mesure selon l'invention permet de relâcher la contrainte sur le pas entre deux ensembles de mesures pour deux angles d'incidence successifs. En effet, selon l'état de la technique, pour obtenir une densité de mesures permettant de discriminer deux courbes d'intensité, il faut réduire le pas $d\alpha$, c'est-à-dire réaliser une faible variation de l'angle d'incidence. Or il n'est pas toujours facile de reconfigurer le système pour réaliser une modification faible de l'angle d'incidence. Avec l'invention, c'est à travers la mesure sur les ordres positifs et les ordres négatifs qu'il est possible d'atteindre la densité requise, en relâchant la contrainte sur la valeur de $d\alpha$, qui peut être choisie un peu plus grande.

Si, dans le mode de réalisation présenté ci-dessus, la mire est un réseau présentant une périodicité selon la direction y0 uniquement (formant ainsi des lignes s'étendant selon la direction x0), la mire peut en outre présenter une structure périodique selon la direction x0. Si dans le mode de réalisation présenté ci-dessus, la cas d'une mire gravé sur un échantillon a été présenté, le procédé s'applique à tout objet présentant au moins une périodicité locale selon une direction.

**Revendications**

1. Procédé (100) amélioré de mesure mettant en oeuvre une technique par diffusion des rayons X aux petits angles en incidence rasante (GISAXS) d'une grandeur relative à un motif périodique formant un réseau de lignes gravé sur un échantillon (10), consistant à :

   - placer (110) le réseau de lignes dans un faisceau de rayons X de manière à créer un désalignement ($\varphi$) entre le réseau de lignes et un plan d'incidence (PI);
   - éclairer (130) le réseau de lignes sous un angle d'incidence ($\alpha$) donné ;
   - mesurer (140) la grandeur sur la figure de diffraction obtenue pour une pluralité de tâches de Bragg, la pluralité de tâches de Bragg comportant une ou plusieurs tâche(s) de Bragg d'ordre positif et une ou plusieurs tâche(s) de Bragg d'ordre négatif.

2. Procédé de mesure selon la revendication 1, dans lequel, le désalignement ($\varphi$) est **caractérisé par** un angle de désalignement, l'angle de désalignement est sélectionné entre 0,01° et 1°, de préférence égale à 0,1°.

3. Procédé de mesure selon la revendication 1 ou la revendication 2, dans lequel l'étape de mesure (140) est itérée (160) pour une succession d'angles d'incidence.

4. Procédé selon la revendication 3, dans lequel, étant défini un ensemble d'angles d'incidence s'étendant entre une valeur minimale ($\alpha_{min}$) et une valeur maximale $\alpha_{max}$, par pas de longueur prédéfinie ($d\alpha$), l'étape de mesure est itérée pour chaque angle d'incidence dudit ensemble.

**5.** Procédé de mesure selon l'une quelconque des revendications précédentes, dans lequel la grandeur mesurée est sélectionnée parmi une position ($q_z$) de la tâche de Bragg considérée dans l'espace réciproque et une intensité (I) de la tâche de Bragg considérée.

**6.** Procédé de mesure selon l'une quelconque des revendications précédentes, dans lequel, suite à l'étape de mesure, les grandeurs mesurées permettent d'ajuster une courbe d'intensité qui dépend d'un facteur de forme du réseau de lignes, afin de déterminer un profil probable du réseau de lignes.

**7.** Système instrumental (1) du type par diffusion des rayons X aux petits angles en incidence rasante - (GISAXS), comportant un calculateur (40) et un détecteur (20) connecté au calculateur, **caractérisé en ce que** le calculateur est convenablement programmé pour que ledit système instrumental mette en oeuvre un procédé de mesure selon l'une quelconque des revendications 1 à 6 pour mesurer une grandeur relative à un réseau de lignes gravé sur un échantillon (10).

**8.** Produit programme d'ordinateur comportant des instructions logicielles qui, lorsqu'elles sont exécutées par un calculateur d'un système instrumental conforme à la revendication 7 permet à ce dernier de mettre en oeuvre un procédé selon l'une quelconque des revendications 1 à 6.

FIG.1

EP 4 390 382 A1

FIG.2

FIG.3

FIG.4

EP 4 390 382 A1

FIG.5

12

```
Début                                                           100

                Désaligner les lignes de la mire et le plan d'incidence des rayons X d'un angle φ
160                                                                              110

α = α_min +dα              α = α_min        120

                        Eclairer l'échantillon        130

                                p = 1        141
                                                        142              140
                        Mesurer position (intensité) de l'ordre positif p
    p = p+1
                        Mesurer position (intensité) de l'ordre négatif –p
    145                                                          143
                    N        p = p_max ?        144
                                        O
            N        α = α_max ?        150
                                O
                        Fin
```

FIG.6

EP 4 390 382 A1

FIG.7

Europäisches
Patentamt

European
Patent Office

Office européen
des brevets

# RAPPORT DE RECHERCHE EUROPEENNE

**Numéro de la demande**

**EP 23 21 9647**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | MIKA PFL\"UGER ET AL: "Extracting Dimensional Parameters of Gratings Produced with Self-Aligned Multiple Patterning Using GISAXS", ARXIV.ORG, CORNELL UNIVERSITY LIBRARY, 201 OLIN LIBRARY CORNELL UNIVERSITY ITHACA, NY 14853, 18 octobre 2019 (2019-10-18), XP081588569, DOI: 10.1117/1.JMM.19.1.014001 * figure 7 * * Partie 3 * * figure 2 * * figure 3b * * Partie 1, Page 2, Col. 2 * ----- | 1-8 | INV. G01N23/201 G01N23/2055 G03F7/00 G01B15/04 |
| X | US 2016/266056 A1 (RUTH RONALD D [US] ET AL) 15 septembre 2016 (2016-09-15) * figures 4A-D, 5,6 7A-D * * alinéa [0047] * ----- | 1-8 | |
| A | WERNECKE JAN ET AL: "Direct structural characterisation of line gratings with grazing incidence small-angle x-ray scattering", REVIEW OF SCIENTIFIC INSTRUMENTS, AMERICAN INSTITUTE OF PHYSICS, 2 HUNTINGTON QUADRANGLE, MELVILLE, NY 11747, vol. 83, no. 10, 1 octobre 2012 (2012-10-01), pages 103906-103906, XP012161407, ISSN: 0034-6748, DOI: 10.1063/1.4758283 [extrait le 2012-10-17] * le document en entier * ----- | 1 | **DOMAINES TECHNIQUES RECHERCHES (IPC)** G01N |

−/−−

Le présent rapport a été établi pour toutes les revendications

| Lieu de la recherche | Date d'achèvement de la recherche | Examinateur |
|---|---|---|
| La Haye | 25 avril 2024 | Gilow, Christoph |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..................................................................................
& : membre de la même famille, document correspondant

EPO FORM 1503 03.82 (P04C02)

EP 4 390 382 A1

**Europäisches Patentamt**
**European Patent Office**
**Office européen des brevets**

# RAPPORT DE RECHERCHE EUROPEENNE

**Numéro de la demande**

**EP 23 21 9647**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | SOLTWISCH VICTOR ET AL: "Investigating surface structures by EUV scattering", PROCEEDINGS OF SPIE; [PROCEEDINGS OF SPIE ISSN 0277-786X VOLUME 10524], SPIE, US, vol. 10143, 24 mars 2017 (2017-03-24), pages 101430P-101430P, XP060088023, DOI: 10.1117/12.2258044 ISBN: 978-1-5106-1533-5 * le document en entier * ----- | 1 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 25 avril 2024 | Gilow, Christoph |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................................................
& : membre de la même famille, document correspondant

EPO FORM 1503 03.82 (P04C02)

16

EP 4 390 382 A1

## ANNEXE AU RAPPORT DE RECHERCHE EUROPEENNE
## RELATIF A LA DEMANDE DE BREVET EUROPEEN NO.

EP 23 21 9647

25-04-2024

| Document brevet cité au rapport de recherche | Date de publication | Membre(s) de la famille de brevet(s) | Date de publication |
|---|---|---|---|
| US 2016266056 A1 | 15-09-2016 | US 2016266056 A1 | 15-09-2016 |
| | | WO 2016145147 A1 | 15-09-2016 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M. YAN ; A. GIBAUD.** On the intersection of grating truncation rods with the Ewald sphère studied by grazing-incidence small-angle X-ray scattering. *Journal of Applied Crystallography,* 2007, vol. 40, 1050-1055